# FASCICULE DE BREVET EUROPEEN

(11) **EP 0 448 483 B1**
(45) Date de publication et mention de la délivrance du brevet: **20.07.1994**
(21) Numéro de dépôt: 91420092.8
(22) Date de dépôt: 19.03.1991
(51) Int. Cl.: G01R 1/073

(54) **Appareil de test de circuit imprimé**
Testgerät für integrierte Schaltkreise
Apparatus for testing integrated circuits

(30) Priorité: 21.03.1990 FR 9003920
(43) Date de publication de la demande: 25.09.1991
(73) Titulaire: INTERNATIONAL MARKET DEVELOPMENT S.A.R.L., F-91953 Les Ulis Cedex (FR)
(72) Inventeur: Vaucher, Christophe, F-38000 Grenoble (FR)
(74) Mandataire: de Beaumont, Michel

(56) Documents cités:
- EP-A- 0 354 080
- DE-A- 3 312 436
- DE-U- 8 427 884
- FR-A- 2 608 775
- IBM TECHNICAL DISCLOSURE BULLETIN vol. 22, no. 7, décembre
- 1979, pages 2824-2826; GLADSTEIN et al.: "Low force microcircuit probe"
- PUBLICATION DE "FEINMETALL GMBH" novembre 1987, Herrenberg,DE; "Prüfköpfe für den IC-Test"

## Description

La présente invention concerne un appareil de test de circuit imprimé et plus particulièrement un tel appareil permettant de tester des circuits imprimés dans lesquels des motifs répétitifs standards apparaissent. L'invention s'applique notamment au test de circuits imprimés comprenant des plages de métallisation adaptées à recevoir des circuits intégrés montés selon la technologie dite TMS (technologie de montage en surface).

Ces dernières années, est apparue une tendance à passer pour le montage de composants sur des circuits imprimés d'un montage en insertion à un montage en surface. Dans le montage en insertion, chaque broche d'un composant passe dans un trou prévu dans le circuit imprimé et la soudure se fait à la vague à partir de la face arrière du circuit imprimé, c'est-à-dire la face opposée à celle portant les composants. Dans le montage en surface, les broches des composants sont repliées pour avoir leurs extrémités parallèles au plan de montage ou pour être tangentes à celui-ci sur au moins une partie de leur longueur. Ces extrémités repliées sont posées sur des plages métallisées prévues sur un circuit imprimé et sont soudées ainsi en surface, par exemple à la vague.

Parmi les nombreux avantages connus de la technologie de montage en surface, on peut noter le fait que les broches des composants et les plages de métallisation sur lesquelles elles reposent peuvent être miniaturisées par rapport au cas des composants montés par insertion.

Toutefois, cet avantage entraîne l'apparition de nouvelles difficultés en ce qui concerne le test de ces circuits imprimés avant montage des composants.

En effet, avant de monter des composants sur un circuit imprimé, le fabricant souhaite d'abord vérifier qu'il n'existe aucune erreur dans la réalisation du circuit imprimé. Il est important que ce test du circuit imprimé nu soit réalisé de façon particulièrement minutieuse car, s'il existe un défaut initial sur la carte de circuit imprimé, on risque de gaspiller tous les composants qui y seront ultérieurement montés ou à tout le moins d'entraîner des opérations de démontage relativement hasardeuses et coûteuses.

Pour tester de façon satisfaisante un circuit imprimé, il convient d'accéder à toutes les plages métallisées destinées à la connexion de composants pour faire des tests d'équipotentielles.

Pour relier un appareil de test et les circuits de test qu'il incorpore aux plages métallisées d'un circuit imprimé, divers moyens sont connus, parmi lesquels le plus répandu actuellement est un système de connexion dit à "lit de clous". Dans ce système, des tiges métalliques, appelées clous, pointes ou aiguilles selon le cas, viennent s'appuyer sur les emplacements à tester du circuit imprimé et sont munies d'un système à ressort. Les clous sont généralement guidés par une ou plusieurs plaques de guidage perforées pour permettre de venir contacter exactement les emplacements prévus du circuit imprimé à tester. La plaque de guidage inférieure peut être percée par un système à commande numérique piloté par des informations, provenant par exemple d'une bande magnétique, correspondant aux informations qui ont permis de déterminer les positions des plages métallisées sur le circuit imprimé. Ainsi, l'utilisation d'un lit de clous implique pour l'utilisateur de s'être équipé d'un ensemble d'appareillages, à savoir, notamment, le lit de clous lui-même, et les équipements mécaniques et informatiques pour perforer la plaque de guidage inférieure.

Quand on veut tester des circuits prévus pour des composants montés en surface, le pas des plages de connexion de ces composants devient trop faible pour contacter chaque plage de contact directement avec l'un des clous.

On est ainsi amené à reporter sur le circuit imprimé des points de test reliés par des connexions à chacune des plages de contact pour retrouver un espacement compatible avec un lit de clous.

Une telle solution est malsaine car, d'une part, elle complique le dessin du circuit imprimé, d'autre part, elle ne permet pas de tester des défauts existants entre les points de test reportés et les plages de contact elles-mêmes alors qu'il s'agit généralement des zones les plus serrées du circuit imprimé et donc des zones qu'il conviendrait de tester avec le plus grand soin.

Un objet de la présente invention est de résoudre le problème de l'accès pour un test à des structures de plages de connexion standards, correspondant par exemple à des plages de contact de circuit intégré à montage en surface tout en conservant autant que faire se peut les systèmes connus à lit de clous pour lesquels de nombreux utilisateurs sont déjà équipés.

Pour résoudre ce problème, le document EP-A-0 354 080 prévoit un appareil de test d'un circuit imprimé dans lequel la liaison entre le circuit à tester et les circuits de test de l'appareil est assurée par des clous conducteurs guidés par au moins une plaque de guidage perforée, dans lequel le circuit à tester comprend au moins un motif standard faisant partie d'un ensemble prédéterminé de motifs standards sensiblement conducteurs à pas serré, comprenant, au niveau de chaque motif standard une plaquette dont une première face située du oôté du circuit à tester comporte un premier motif de plots disposés selon ledit motif standard et dont la deuxième face comporte un deuxième motif de plots disposés régulièrement à un pas compatible avec celui des clous, chaque plot de la première face étant électriquement connecté à un plot de la deuxième face.

Toutefois, une telle structure présente l'inconvénient de nécessiter un très grand nombre de plaquettes standards pour s'adapter aux nombreux motifs standards existants.

Pour résoudre ce problème, la présente invention propose la solution présentée dans la partie caractérisante de la revendication 1.

Pour améliorer la qualité des contacts, la présente invention propose diverses solutions présentées dans les revendications dépendantes.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1 représente à titre d'exemple une portion de circuit imprimé destinée à recevoir des composants à montage en surface ;
la figure 2 représente des points de test déportés selon l'art antérieur ;
les figures 3A, 3B et 3C représentent respectivement une vue de dessus d'une portion de circuit imprimé, une vue de dessous d'une plaquette et une vue de dessus d'une plaquette ;
la figure 4 représente de façon schématique et simplifiée le montage d'une plaquette ; et
la figure 5 représente de façon un peu plus détaillée quoiqu'encore très schématique le montage d'une plaquette ;
la figure 6 représente en vue de dessous un mode de réalisation d'une plaquette selon la présente invention ; et
la figure 7 représente une vue en coupe partielle correspondant au mode de réalisation de la figure 6.

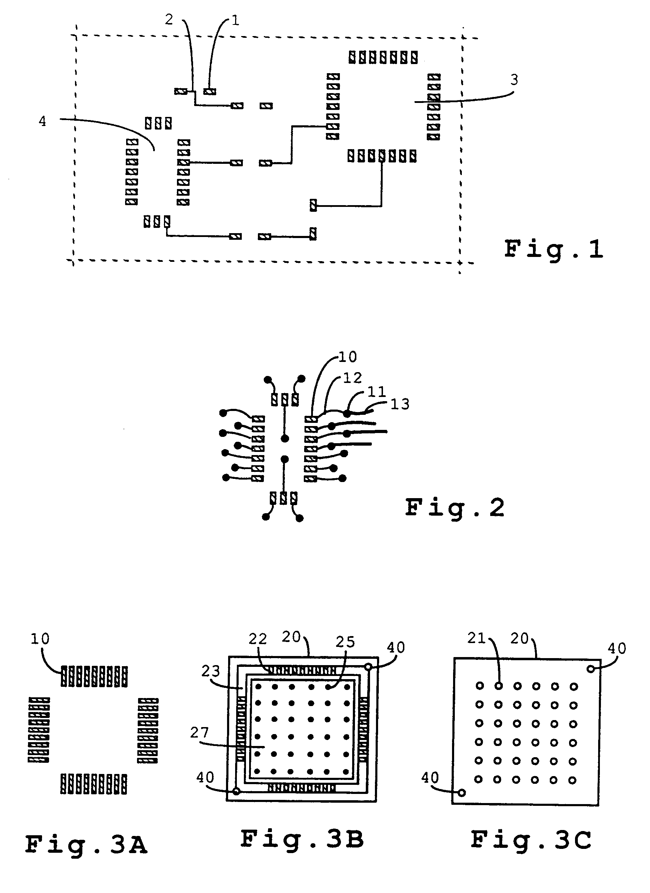

La figure 1 représente de façon arbitraire et schématique une portion de circuit imprimé. On y distingue diverses plages de contact 1 et connexions 2 entre plages de contact. Deux régions 3 et 4 comprennent des plages de contact régulièrement disposées destinées à recevoir des boîtiers multibroches montés en surface. Bien entendu, des connexions non représentées partent des diverses plages de contact vers d'autres plages de contact du circuit imprimé ou vers des traversées débouchant sur l'autre face ou sur une couche intermédiaire du circuit imprimé.

Les régions 3 et 4 destinées au montage de composants à montage en suface se distinguent par le fait qu'elles comportent selon un contour sensiblement rectangulaire des plages de contact très proches les unes des autres destinées à recevoir les broches d'un boîtier de circuit intégré. Bien qu'il existe de très nombreux types de circuits intégrés, leurs boîtiers et la répartition des plages de contact correspondantes sont normalisés et il existe un nombre limité de boîtiers standards. Ainsi, l'une des idées sur lesquelles se base la présente invention est que, si l'on arrive à résoudre le problème de la prise de contact vers des plages de contact correspondant à des boîtiers standards, on aura résolu un problème d'une façon qui pourra être répétitive.

La figure 2 illustre très schématiquement une façon dont on résoud dans l'art antérieur le problème de l'accès par des clous d'un lit de clous à des plages métallisées 10 très proches telles que les plages de contact d'un boîtier à montage en surface. Un plot de test 11 est relié à chaque plage de contact par l'intermediaire d'un conducteur 12 qui fait éventuellement partie du conducteur 13 auquel doit être relié la zone de contact.

La figure 3A représente à nouveau des plages métallisées 10 correspondant par exemple aux contacts d'un composant à montage en surface.

Comme le document EP-A-0 354 080, la présente invention prévoit d'associer à chaque ensemble de plages métallisées tel que celui illustré en figure 3A une structure intermédiaire telle qu'une plaquette de circuit imprimé 20. La face inférieure de la plaquette, du côté du circuit à tester, est représentée en figure 3B et la face supérieure, du côté des clous, est représentée en figure 3C.

La face supérieure porte un ensemble de plots de contact 21 disposés à un pas correspondant à celui des clous. La face inférieure comprend des plots de contact 22 disposés selon le même motif que les plages métallisées 10 et destinés à venir s'apposer sur celles-ci par l'intermédiaire d'une feuille ou de bandes 23 d'un matériau élastique à conduction anisotrope, c'est-à-dire conducteur dans le sens de son épaisseur et non dans les autres directions. Un tel matériau est connu en lui-même et on a même essayé dans l'art antérieur de l'utiliser comme interface de test complète de circuit imprimé. Toutefois, ceci a conduit à des solutions complexes et onéreuses difficilement compatibles avec une utilisation industrielle.

La plaquette de circuit imprimé 20 comprend des moyens pour relier les zones de contact 22 sur la face inférieure aux plots de contact 21 sur la face supérieure. Ceci peut se faire par des traversées 25 représentées schématiquement en figure 3B et dont chacune est reliée par une connexion non représentée à l'un des plots 22. On peut également prévoir une plaquette de circuit imprimé multicouche, les connexions entre une face et l'autre se faisant par des traversées partielles et des conducteurs au moins partiellement dans une couche intermédiaire. On prévoiera de préférence en outre, une feuille de matériau isolant 27 disposée à l'intérieur d'un cadre ou de bandes de matériau à conduction anisotrope 23, recouvrant uniquement, et éventuellement partiellement, les régions de contact.

Comme on l'a indiqué précédemment, étant donné que la disposition des broches des boîtiers à montage en surface est normalisée, il suffira de préparer des lots de plaquettes correspondant aux dimensions normalisées pour les monter ensuite sur la plaque de guidage inférieure d'un système de connexion à lit de clous.

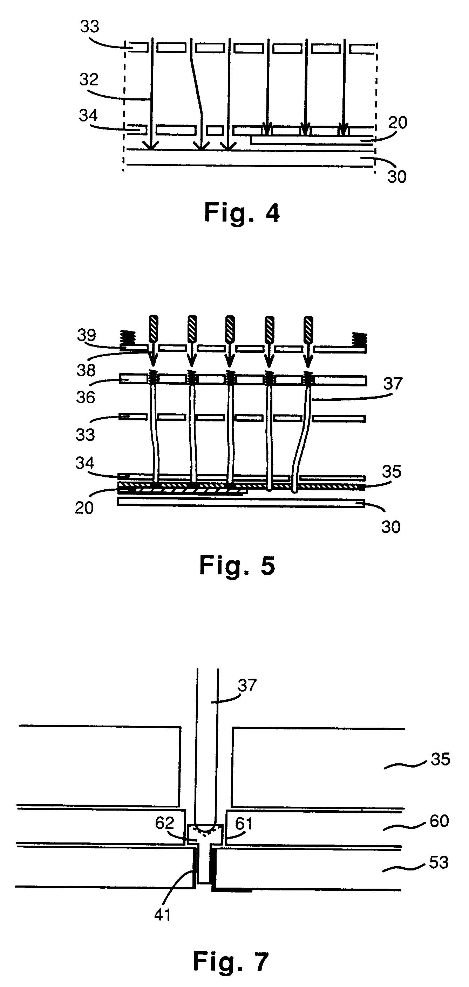

Ceci est illustré schématiquement en figure 4 dans laquelle on a représenté une plaquette 20 disposée au-dessus d'un circuit imprimé à tester 30 ainsi qu'un système à lit de clous comprenant des clous 32 guidés par des plaques de guidage 33 et 34, la plaque de guidage 34 étant au voisinage immédiat de la face à tester du circuit imprimé. Comme on le voit sur la figure, certains clous (à droite de la figure) viennent prendre appui sur les plots de contact supérieurs 21 de la plaquette 20 tandis que les autres clous (à gauche de la figure) viennent directement en contact avec des plages métallisées du circuit imprimé à tester.

La figure 5 représente de façon quelque peu plus détaillée un mode de réalisation du système utilisé selon la présente invention. On y voit la carte de circuit imprimé à tester 30, une plaquette 20 selon la présente invention, des plaques de guidage 33 et 34, une plaque de guidage supplémentaire 35 destinée à la fixation des plaquettes 20, une plaque 36 de montage sur ressort d'aiguilles de contact 37 elles-même poussées par des clous 38 montés dans une plaque 39.

Dans ce qui précède, l'emploi des mots inférieur et supérieur est relatif. En effet, on pourra notamment procéder à un test simultané des faces supérieure et inférieure d'une carte de circuit imprimé.

La fixation des plaquettes préfabriquées selon la présente invention à la plaque de guidage 34 (figure 4) ou à la plaque intermédiaire 35 (figure 5) peut se faire par tout moyen approprié, par exemple par collage.

En revenant sur les figures 3B et 3C, on notera que l'on pourra prévoir des trous ou ergots de positionnement 40 sur les plaquettes 20, des moyens complémentaires étant prévus sur la plaque inférieure 34 ou 35.

Ainsi, un utilisateur souhaitant tester un circuit imprimé, pourra utiliser un montage à lit de clous classiques. Il préparera des perçages dans la plaque de guidage inférieure 33 aux emplacements correspondant aux zones qu'il souhaite directement contacter sur le circuit imprimé. En ce qui concerne les portions du circuit imprimé destinées à recevoir des boîtiers à montage en surface, il pourra utiliser des plaquettes préfabriquées selon la présente invention qu'il collera simplement sur la plaque de guidage inférieure qui comportera alors un réseau d'orifices réguliers et éventuellement des moyens de positionnement. Ceci pourra être réalisé en modifiant très peu un système de prise de contact par lit de clous classique.

L'homme de l'art pourra apporter diverses variantes à la présente invention, notamment en ce qui concerne les choix des matériaux, pour s'adapter à des systèmes à lit de clous particuliers.

Par exemple, le matériau élastique à conduction anisotrope pourra être un polymère tel que le produit MAF disponible auprès de la société japonaise SHIN ETSU d'une épaisseur de l'ordre de 200 micromètres, la feuille isolante 27 pouvant être une feuille de capton d'une épaisseur de l'ordre de 80 à 90 % de celle du polymère.

Les plaquettes 20 pourront être réalisées à partir d'une ou plusieurs plaques isolantes souples ou rigides, dans lesquelles on aura réalisé des trous qui seront ensuite remplis d'un matériau conducteur, par exemple une résine conductrice, et à partir desquels on formera des liaisons conductrices venant relier un plot supérieur à un plot inférieur. Si les plots inférieurs sont en un matériau conducteur élastique, on pourra éviter l'emploi du matériau élastique à conductivité anisotrope susmentionné.

De plus, on pourra prévoir d'assembler en une plaquette unique plusieurs plaquettes selon la présente invention.

Grâce à la prévision de plaquettes standards préfabriquées correspondant à des motifs standards tels que des plages de contact de circuits intégrés à montage en surface, on peut effectuer des tests complets de cartes de circuit imprimé de façon simple et relativement peu coûteuse. En outre, étant donné que les configurations de plages de contact des circuits intégrés à montage en surface correspondent à des standards, seul un nombre limité de plaquettes préfabriquées doit être stocké comme cela a été indiqué précédemment.

Selon l'aspect principal de la présente invention, il est prévu une rationalisation consistant à fabriquer chacune des plaquettes à partir d'un assemblage de barrettes.

Ces barrettes comprennent, sur une première face, des plages conductrices alignées espacées au pas des plages conductrices des motifs standards à tester et, sur leur deuxième face, des plots de contact, à un pas compatible avec celui des clous d'un appareil à lit de clous, chacun de ces plots étant connecté à une plage conductrice. En effet, si l'on considère les divers motifs standards de plages de contact correspondant par exemple à des motifs de contact de circuits intégrés à montage en surface, il existe un petit nombre de pas standards entre contacts. Les divers motifs standards diffèrent les uns des autres essentiellement par le nombre de plages de contact le long de chaque côté d'un contour rectangulaire. Ainsi, au lieu de fabriquer des plaquettes standards, il suffira de fabriquer des barrettes standards aux différents pas normalisés et de découper ces barrettes puis de les assembler selon un motif standard déterminé.

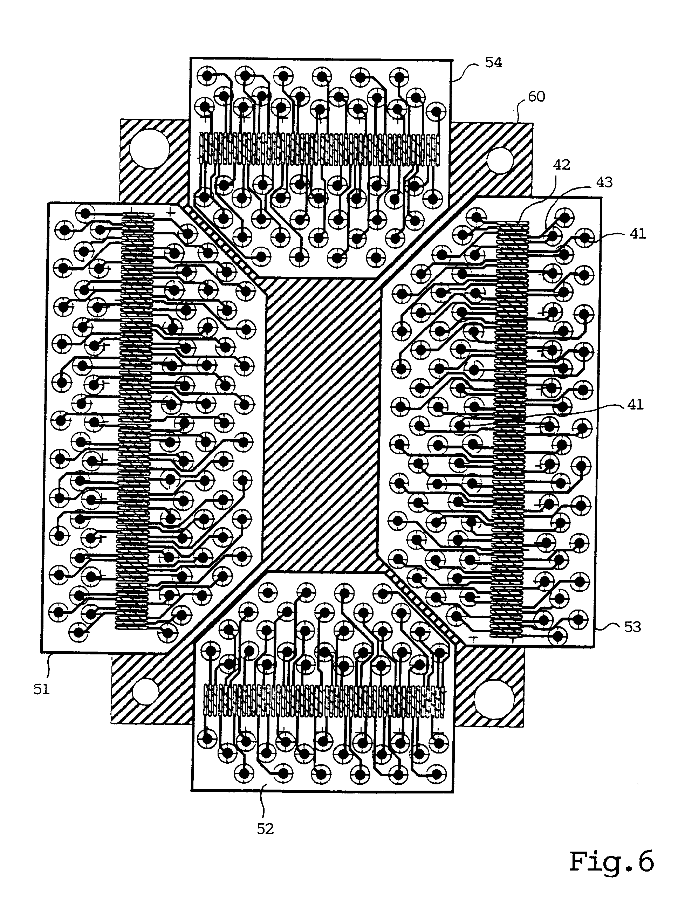

Un exemple d'une telle mise en oeuvre est illustré en figure 6, cette figure étant une vue de dessous comme la figure 3B. Les plages de contact 42 destinées à venir en contact avec des plages conductrices d'un circuit imprimé de la façon décrite précédemment sont reliées par des conducteurs 43 à des plots 41 disposés sur la barrette de part et d'autre des plages de contact 42 selon un motif régulier de sorte qu'une barrette de grande longueur peut être découpée à une longueur choisie correspondant à un circuit donné. En figure 6, quatre barrettes ou morceaux de barrettes 51, 52, 53, 54 sont montés sur une plaquette support 60. Cette plaquette support 60 pourra être montée sur une plaque 34 ou 35 d'un appareil à lit de clous de la même façon que la plaquette 20 de la figure 5.

Bien entendu, la plaquette support 60 doit comprendre des ouvertures ou des contacts traversant en correspondance avec chacun des plots 41 des barrettes.

Chacune des barrettes peut être formée d'un morceau de carte de circuit imprimé et le support 60 être en résine époxy.

Un exemple de réalisation particulier de l'assemblage entre une barrette 53 et une plaquette support 60, elle-même solidaire d'une plaque inférieure 35 d'un système à lit de clous, est illustré dans la vue en coupe partielle de la figure 7. Cette vue en coupe est prise au niveau d'un plot de contact 41.

Dans le mode de réalisation représenté, le plot de contact 41 est en fait constitué d'un trou métallisé formé dans la barrette 53. En face de chaque trou métallisé 41, la plaque support 60 comprend une ouverture 61. Un pion métallique 62 de forme cylindrique, dont la partie inférieure est au diamètre inférieur du trou métallisé 41 (ou à un diamètre inférieur avec une collerette en surépaisseur) et dont la partie de tête est sensiblement au diamètre intérieur de l'ouverture 61, est monté de la façon illustrée en figure 6 et assure le positionnement relatif de chaque barrette 53 et de la plaque 60 et leur blocage. Le pion 62 assure également la fonction de report de contact, sa tête comprenant une échancrure conique destinée à recevoir l'extrémité d'une aiguille 37 de l'appareil à lit de clous. Ce système particulièrement simple permet d'utiliser un grand nombre de fois les barrettes 53 sans provoquer une usure excessive.

A titre d'exemple pratique, on notera que la plaque 35, par exemple en Plexiglas, peut avoir une épaisseur de l'ordre de 10 mm, la plaque support 60 une épaisseur de 0,8 à 1,6 mm, et la barrette 53 une épaisseur de 0,8 mm.

La présente invention est susceptible de diverses variantes et modifications qui apparaîtrons à l'homme de l'art. En particulier, on a décrit précédemment les zones de contact sur la plaquette selon l'invention comme ayant la forme de régions rectangulaires allongées conformes aux zones métallisées sur le circuit imprimé à tester. Comme on l'a exposé précédemment, ces zones de contact, dans un mode de réalisation de l'invention, sont connectées aux zones métallisées par des bandes d'un matériau élastique conducteur dans le sens de son épaisseur. Ce matériau nécessite qu'il existe une distance d'isolement minimum entre zones de contact adjacentes. Pour accroître la densité des contacts, on pourra former des zones de contact adjacentes en quinconce sur une partie seulement de la longueur des régions rectangulaires susmentionnées, ce qui augmente la distance électrique entre zones de contact adjacentes.

## Revendications

1. Appareil de test d'un circuit imprimé dans lequel la liaison entre des plages conductrices du circuit à tester et les circuits de test de l'appareil est assurée par des clous conducteurs (32) guidés par au moins une plaque de guidage perforée (34), dans lequel le circuit à tester (30) comprend au moins un motif standard faisant partie d'un ensemble prédéterminé de motifs standards de plages conductrices à pas serré, cet appareil comprenant, au niveau de chaque motif standard une plaquette (20) dont une première face située du côté du circuit à tester comporte un premier motif de plots (22) disposés selon ledit motif standard et dont la deuxième face comporte un deuxième motif de plots (21) disposés régulièrement à un pas compatible avec celui des clous, chaque plot de la première face étant électriquement connecté à un plot de la deuxième face, caractérisé en ce que chaque plaquette est constituée d'une plaquette support (60) sur laquelle sont montées des barrettes (51-54) portant chacune un motif de plages de contact alignées correspondant à un côté du motif standard à tester.

2. Appareil de test selon la revendication 1, caractérisé en ce que les plots et les connexions électriques de traversée d'une face à l'autre correspondent à des dépôts de matière conductrice.

3. Appareil de test selon la revendication 1, caractérisé en ce que chacune desdites plaquettes (20) est fixée à une plaque de guidage (34, 35) disposée au voisinage immédiat du circuit à tester (30).

4. Appareil de test selon la revendication 3, caractérisé en ce que la plaque de guidage et la plaquette comprennent des moyens de positionnement complémentaires (40) de sorte que les clous traversant la plaque de guidage arrivent contre le deuxième motif de plots (21).

5. Appareil de test selon la revendication 1, caractérisé en ce qu'il comprend, en tant qu'interface entre le premier motif de plots sur chaque barrette et le motif standard sur le circuit imprimé, une feuille (23) d'un matériau élastique conducteur dans le sens de son épaisseur et sensiblement isolant dans les autres directions.

6. Appareil de test selon la revendication 5, caractérisé en ce que ledit motif standard correspond à des plages métallisées (10) destinées au montage d'un composant à montage en surface.

7. Appareil de test selon la revendication 6, caractérisé en ce que ladite feuille en matériau élastique conducteur est disposée selon des bandes recouvrant uniquement, et éventuellement partiellement les régions des contacts, la zone centrale libre de la face inférieure de la plaquette étant en outre revêtue d'une feuille isolante (27) moins épaisse que la feuille de matériau élastique.

8. Appareil de test selon la revendication 5, caractérisé en ce que ladite plaquette (20) comprend des voies de passage (25) entre ses deux faces, disposées de façon centrale en regard de la feuille isolante, chaque contact étant relié à ces voies de passage par des métallisations sur la première face protégées par la feuille isolante.

9. Appareil de test selon la revendication 1, caractérisé en ce que les plots de chaque barrette correspondant au deuxième motif de plots sont constitués de trous métallisés (41), chaque trou métallisé étant en regard d'une ouverture de sa plaquette support correspondante et étant assemblé avec celle-ci par une pièce métallique cylindrique à tête cylindrique (62) destinée à recevoir l'extrémité d'une aiguille de l'appareil à lit de clous.

## Patentansprüche

1. Testgerät für eine gedruckte Schaltung, bei der die Verbindung zwischen leitenden Bereichen der zu testenden Schaltung und den Schaltungen des Testgerätes durch leitende Nadeln (32) sichergestellt ist, die durch zumindest eine perforierte Führungsplatte (34) geführt sind, wobei die zu testende Schaltung (30) zumindest ein Standardmuster aufweist, das Teil einer bestimmten Anordnung von Standardmustern für eng benachbarte leitende Bereiche ist, und das Testgerät im Bereich jedes Standardmusters eine Platte (20) aufweist, deren eine auf Seiten der zu testenden Schaltung gelegene erste Oberfläche ein erstes Muster von Kontakten (22) trägt, die entsprechend dem Standardmuster angeordnet sind, und deren zweite Oberfläche ein zweites Muster von Kontakten (21) trägt, die regelmäßig in einem Abstand angeordnet ist, der kompatibel mit dem der Nadel ist, wobei jeder Kontakt der ersten Oberfläche elektrisch mit einem Kontakt der zweiten Oberfläche verbunden ist, dadurch gekennzeichnet, daß jede Platte durch eine Stützplatte (60) gebildet wird, auf der Streifen (51 bis 54) montiert sind, die jeweils ein Muster von Kontaktbereichen tragen, die zu einer Seite des zu testenden Standardmusters ausgerichtet sind.

2. Testgerät nach Anspruch 1, dadurch gekennzeichnet, daß die Kontakte und die elektrischen Durchkontaktierungen von einer Seite auf die andere den Beschichtungen mit leitendem Material entsprechen.

3. Testgerät nach Anspruch 1, dadurch gekennzeichnet, daß jede der Platten (20) auf einer Führungsplatte (34, 35) befestigt ist, die in unmittelbarer Nachbarschaft der zu testenden Schaltung (30) angeordnet ist.

4. Testgerät nach Anspruch 3, dadurch gekennzeichnet, daß die Führungsplatte und die Platte komplementäre Positioniervorrichtungen (40) aufweisen, derart, daß die die Führungsplatte durchsetzenden Nadeln bis zu dem zweiten Kontaktmuster (21) gelangen.

5. Testgerät nach Anspruch 1, dadurch gekennzeichnet, daß es als Zwischenlage zwischen dem ersten Kontaktmuster auf jeder Platte und dem Standardmuster auf der gedruckten Schaltung ein Blatt (23) eines elastischen Materials aufweist, welches in Dickenrichtung leitend und in den anderen Richtungen im wesentlichen isolierend ist.

6. Testgerät nach Anspruch 5, dadurch gekennzeichnet, daß das Standardmotiv metallisierten Bereichen (10) entspricht, die zur Montage eines Bauteils zur Befestigung auf der Oberfläche bestimmt sind.

7. Testgerät nach Anspruch 6, dadurch gekennzeichnet, daß das genannte Blatt aus elastischem elektrisch leitenden Material in Bändern angeordnet ist, die einzig und gegebenenfalls teilweise die Kontaktbereiche überdecken, wobei die zentrale freie Zone der unteren Oberfläche der Platte darüberhinaus mit einem isolierenden Blatt (27) bedeckt ist, welches dünner als das Blatt aus elastischem Material ist.

8. Testgerät nach Anspruch 5, dadurch gekennzeichnet, daß die Platte (20) Durchgangspassagen (25) zwischen ihren beiden Flächen aufweist, die mittig in bezug zu dem isolierenden Blatt angeordnet sind, wobei jeder Kontakt mit diesen Durchgangspassagen über Metallisierungen auf der ersten Oberfläche, die durch das isolierende Blatt geschützt sind, verbunden ist.

9. Testgerät nach Anspruch 1, dadurch gekennzeichnet, daß die Kontakte jeder Platte, die dem zweiten Kontaktmuster entsprechen, durch metallisierte Löcher (41) gebildet sind, wobei jedes metallisierte Loch auf eine Öffnung in seiner entsprechenden Stützplatte ausgerichtet und mit dieser Öffnung über ein zylindrisches Metallstück mit einem zylindrischen Kopf (62) verbunden ist, um die Spitze der Nadeln des Testgerätes aufzunehmen.

## Claims

1. A device for testing a printed circuit board (PCB) (30) wherein the connection between conductive areas of the PCB to be tested and testing circuits is ensured by conductive needles (32) guided by at least one perforated guiding plate (34), wherein the PCB to be tested (30) comprises at least one standard pattern included in a predetermined set of standard patterns of closely-spaced contact regions, said device comprising, at each standard pattern a plate (20), a first surface of which, facing the PCB to be tested, comprises a first pattern of pads (22) arranged according to said standard pattern, and the second surface of which comprises a second pattern of pads (21) regularly arranged according to a pitch compatible with that of the needles, each pad of said first surface being electrically connected to a pad of said second surface, characterized in that each plate is constituted by a supporting plate (60) on which are mounted strips (51-54), each comprising a pattern of aligned contact regions corresponding to a side of the standard pattern to be tested.

2. A testing device according to claim 1, characterized in that said pads and the electric connections passing from one surface to the other correspond to conductive material coatings.

3. A testing device according to claim 1, characterized in that each of said plates (20) is mounted to a guiding plate (34, 35) arranged near said PCB to be tested (30).

4. A testing device according to claim 3, characterized in that said guiding plate and said plate comprise additional positioning means (40) so that said needles passing through said guiding plate abut against said second pattern of pads (21).

5. A testing device according to claim 1, characterized in that it comprises, as an interface between said first pad pattern on each strip and said standard pattern on said PCB, a sheet (23) of an elastic material, depthwise conductive and substantially isolating in the other directions.

6. A testing device according to claim 5, characterized in that said standard pattern corresponds to metallized regions (10) for connecting a surface mounted component (SMC).

7. A testing device according to claim 6, wherein said sheet of conductive elastic material is arranged according to strips overlapping only, and if necessary partially, the contact regions, the free central area of the lower surface of the plate being further coated with an isolating film (27) thinner than the sheet of elastic material.

8. A testing device according to claim 5, characterized in that said plate (20) comprises vias (25) between its two surfaces, centrally arranged and facing the isolating sheet, each contact being connected to said vias by metallizations on the first surface, protected by said isolating sheet.

9. A testing device according to claim 1, characterized in that the pads of each strip corresponding to the second pattern of pads are constituted by metallized vias (41), each metallized via facing an aperture of its corresponding supporting plate and being assembled with the latter by means of a cylindric metal piece having a cylindric head (62) for receiving the extremity of one of said needles.
